(19) Europäisches Patentamt
European Patent Office
Office européen des brevets

(11) Veröffentlichungsnummer: **0 341 560 B1**

(12) **EUROPÄISCHE PATENTSCHRIFT**

(45) Veröffentlichungstag der Patentschrift: **04.05.94**

(51) Int. Cl.$^5$: **C08F 2/50**, C08F 246/00, C09D 133/00, G03F 7/027

(21) Anmeldenummer: **89107971.7**

(22) Anmeldetag: **03.05.89**

# (54) Fotoinitiator Copolymere.

(30) Priorität: **13.05.88 DE 3816304**

(43) Veröffentlichungstag der Anmeldung: **15.11.89 Patentblatt 89/46**

(45) Bekanntmachung des Hinweises auf die Patenterteilung: **04.05.94 Patentblatt 94/18**

(84) Benannte Vertragsstaaten: **BE CH DE FR GB IT LI NL**

(56) Entgegenhaltungen:
**EP-A- 0 003 002**
**EP-A- 0 161 463**
**EP-A- 0 281 941**

(73) Patentinhaber: **CIBA-GEIGY AG**
**Klybeckstrasse 141**
**CH-4002 Basel(CH)**

(72) Erfinder: **Köhler, Manfred, Dr.**
**Hebbelstrasse 38**
**D-6100 Darmstadt(DE)**
Erfinder: **Dorsch, Dieter, Dr.**
**Reuterallee 24**
**D-6100 Darmstadt(DE)**
Erfinder: **Ohngemach, Jörg, Dr.**
**Taubenstrasse 6**
**D-6107 Reinheim(DE)**
Erfinder: **Greber, Gerhard, Prof. Dr.**
**Anzengruberstrasse 11**
**A-2540 Bad Vöslau(AT)**

EP 0 341 560 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft Fotoinitiator-Copolymere, die aus mindestens zwei verschiedenen Monomereinheiten aufgebaut sind, von denen mindestens eine eine fotoinitiierend wirkende Struktureinheit trägt. Derartige Polymerverbindungen dienen als radikalbildende Fotoinitiatoren für die Fotopolymerisation ethylenisch ungesättigter Verbindungen oder solche enthaltender Systeme. Fotoinitiator-Copolymere zeigen eine Reihe vielfach unerwarteter Vorteile gegenüber konventionellen monomeren oder auch hiervon abgeleiteten homopolymeren Fotoinitiatoren.

Fotochemisch induzierte Polymerisationsreaktionen haben in der Technik große Bedeutung erlangt, insbesondere wenn es um eine schnelle Härtung von dünnen Schichten geht, wie z.B. bei der Härtung von Lacküberzügen und Kunststoffbeschichtungen auf Papier, Holz, Metall und Kunststoff oder bei der Trocknung von Druckfarben. Dabei zeichnet sich die Strahlungshärtung in Gegenwart von Fotoinitiatoren gegenüber konventionellen Methoden zum Trocknen oder Härten von Beschichtungen durch Rohstoff- und Energieersparnis, geringe thermische Belastung des Untergrundes, und insbesondere eine hohe Geschwindigkeit aus. Aber auch die Herstellung von Polymermaterialien an sich durch Polymerisation entsprechender ungesättigter monomerer Ausgangsmaterialien erfolgt vielfach fotochemisch und mit Hilfe von Fotoinitiatoren, wobei übliche Verfahren, wie Lösungs- und Emulsionspolymerisationen zur Anwendung gelangen.

Weiterhin finden Fotoinitiatoren vielfach Verwendung in fotopolymerisierbaren Zusammensetzungen für photolithographische Prozesse, wie insbesondere in Negativ-Fotoresists in der Halbleiterelektronik und der Optoelektronik, Verwendung.

Da bei den genannten Reaktionen in der Regel keiner der Reaktionspartner in der Lage ist, die fotochemisch wirksame Strahlung in ausreichendem Maße zu absorbieren, müssen Fotoinitiatoren zugesetzt werden, die in der Lage sind, entweder eingestrahlte energiereiche Strahlung, meist UV-Licht, zu absorbieren und dabei aktive Starterradikale zu bilden, die ihrerseits die Fotopolymerisation auslösen, oder die aufgenommene Energie zur Radikalbildung auf einen der polymerisierbaren Reaktionspartner zu übertragen. An der eigentlichen Polymerisationsreaktion nehmen die Initiatoren normalerweise nicht teil.

Hierfür geeignete Fotoinitiatoren sind überwiegend Verbindungen vom Typ der aromatischen Ketone, wie Benzophenone, Benzoinether, Benzilmonoketale, Dialkoxyacetophenone, Thioxanthone, Bisacylphosphinoxide oder Hydroxyalkylphenone sowie von diesen Strukturtypen abgeleitete Derivate. Als besonders vorteilhaft haben sich Hydroxyalkylphenon-Fotoinitiatoren, wie sie in den Patentschriften DE-PS 27 22 264 und EP-PS 3002 beschrieben sind, erwiesen, vornehmlich aufgrund ihrer hohen Reaktivität, aber auch wegen der vorzüglichen Dunkellagerstabiltät der mit ihnen versetzten strahlungshärtbaren Systeme sowie der geringen Neigung der damit gehärteten Schichten zu vergilben.

Die fortschreitende Diversifizierung und Spezialisierung von Verfahren und Produkten auf dem Sektor der Beschichtungstechnik mit Polymermaterialien und das vermehrt einhergehende Erfordernis von maßgeschneiderten Probemlösungen bringt es mit sich, daß auch an Fotoinitiatoren immer höhere und spezifischere Anforderungen gestellt werden. Fotoinitiatoren konventioneller Art erfüllen daher vielfach nicht oder zumindest nicht optimal die heute an sie gestellten Forderungen. Diese gehen zunehmend dahin, daß Fotoinitiatoren mehr noch leisten sollen als lediglich nur die Fotopolymerisation bzw. Fotovernetzung auslösende Radikale bilden zu können. Wesentliche Problemkreise hierbei sind beispielsweise die Kompatibilität in den unterschiedlichsten Systemen, insbesondere auch solchen, die zur Erzielung bestimmter Materialeigenschaften auch nicht fotopolymerisierbare Anteile enthalten (sogen. Hybridsysteme) sowie weiterhin der migrationsfeste Einbau von Fotoinitiator bzw. seinen Fotolyseprodukten in das fotopolymerisierte Endprodukt. Gleichzeitig sollen die zusätzlichen Eigenschaften die Fotoreaktivität des Initiators unbeeinflußt lassen; eine hohe Dunkellagerstabilität der damit versehenen Systeme ist für die praktische Verwendbarkeit ebenfalls von hohem Stellenwert.

Weiterentwicklungen in diese Richtungen wurden bereits betrieben, vornehmlich ausgehend von den bezüglich Fotoreaktivität besonders leistungsfähigen Hydroxyalkylphenon-Fotoinitiatoren. So sind beispielsweise die in DE-OS 35 12 179 beschriebenen Fotoinitiatoren besonders für den Einsatz in wäßrigen Systemen geeignet. Die ungesättigt funktionalisierten Fotoinitiatoren aus DE-OS 35 34 645 und EP-OS 161463 sowie die besonders vielseitigen coreaktiven Fotoinitiatoren der deutschen Patentanmeldungen P 37 07 891 und P 37 38 567 ermöglichen den migrationsfesten Einbau in das Produkt durch fotochemisch und nicht-fotochemisch induzierte Co-Reaktion mit den unterschiedlichsten Systembestandteilen, mit sich selbst oder mit dem Substrat vor, während oder auch nach der eigentlichen Fotopolymerisation.

Diese vom Prinzip her vielversprechenden Weiterentwicklungen sind aber noch vielfach verbesserungswürdig. So sind in den modifizierten Fotoinitiatoren der vorstehende zitierten Schriften überwiegend jeweils immer nur einzelne spezifische Zusatzeigenschaften realisierbar. Für die verschiedensten Anforderungen und Einsatzwecke müssen daher eine Vielfalt von entsprechend modifizierten Fotoinitiatoren von Grund auf

synthetisiert und bereitgehalten werden, was einen hohen Aufwand erfordert und daher wenig wirtschaftlich ist.

Der Erfindung lag daher die Problemstellung zugrunde, leistungsfähige Fotoinitiatoren aufzufinden und bereitzustellen, mit denen sich einerseits eine Vielfalt maßgeschneiderter zusätzlicher Eigenschaften realisieren lassen und die aber andererseits einfach zugänglich sind, etwa ausgehend von einigen wenigen universell einsetzbaren Grundbausteinen.

Es wurde nun gefunden, daß diese Anforderungen in hervorragender Weise erfüllt werden von Fotoinitiator-Copolymeren mit Molmassen zwischen 500 und 1.000.000, erhältlich durch Copolymerisation von zumindest zwei unterschiedlichen Monomereinheiten der Formeln I und II im Verhältnis I/II = 1-100

(I) 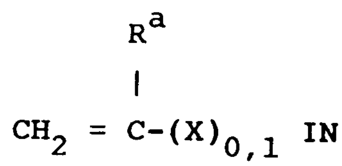

(II) 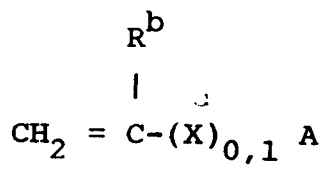

worin bedeutet

| | |
|---|---|
| $R^a$, $R^b$ | jeweils unabhängig voneinander H, Cl, CN, $C_{1-6}$-Alkyl oder Phenyl, |
| X | CO-, COO-, O-CO-, $(CH_2)_nY$, $COO(CH_2)_nY$, $CO(OCH_2CH_2)_nY$ mit n = 1-10 und Y eine eine Einfachbindung, -O-, -S-, -CO-, -COO-, -OCO-, -NH-, -N($C_{1-6}$-Alkyl)-, |
| IN | eine der Fotoinitiatorgrundstrukturen |

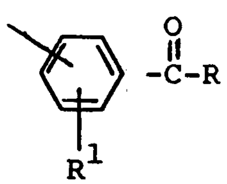 oder 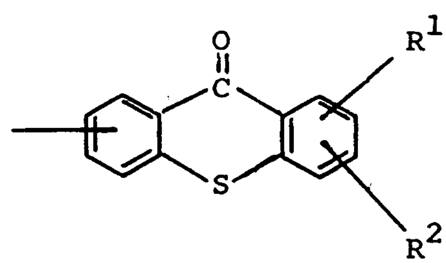

worin

| | |
|---|---|
| R | $-CR^3R^4R^5$ oder |

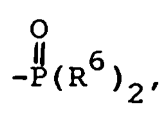

und

| | |
|---|---|
| $R^1$, $R^2$ | H, Halogen, $C_{1-12}$-Alkyl oder $C_{1-12}$-Alkoxy, |
| $R^3$, $R^4$ | jeweils unabhängig voneinander H, $C_{1-12}$-Alkyl, $C_{1-12}$-Alkenyl, $C_{1-12}$-Alkoxy oder zusammen $C_{2-6}$-Alkylen, |
| $R^5$ | -OH, $C_{1-6}$-Alkoxy, $C_{1-6}$-Alkanoyloxy, $-N(C_{1-6}\text{-Alkyl})_2$, |

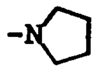 , 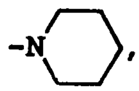, 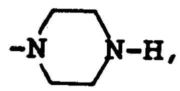

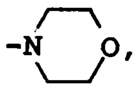

$-SO_2R^7$, $-OSO_2R^7$,

$R^6$ $C_{1-6}$-Alkyl, $C_{1-6}$-Alkanoyl, Phenyl oder Benzoyl, jeweils gegebenenfalls mit Halogen, $C_{1-6}$-Alkyl oder $C_{1-6}$-Alkoxy substituiert

$R^7$ $C_{1-6}$-Alkyl, Phenyl

darstellt,

A eine der Fotoinitiatorgrundstrukturen IN mit den oben angegebenen Bedeutungen, oder H, $C_{1-12}$-Alkyl, $C_{1-12}$-Alkenyl, Phenyl, Styryl, Halogen, NCO, NCS, $N_3$, $SO_3H$, $SO_2Cl$, $CR^c=CR^dR^e$ oder

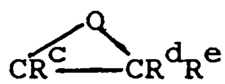

mit $R^c$, $R^d$, $R^e$ jeweils H oder $CH_3$, $SiR^fR^gR^h$ mit $R^f$, $R^g$, $R^h$ jeweils Cl, $C_{1-12}$-Alkyl, -Alkoxy, -Alkanoyloxy.

Die erfindungsgemäßen Copolymere sind leistungsfähige, individuell strukturierbare Fotoinitiatoren für die Fotopolymerisation bzw. Fotovernetzung ethylenisch ungesättigter Verbindungen bzw. solche enthaltender Systeme. Sie können aber auch selbst als gleichzeitig fotoinitiierend wirkende und schichtbildende Komponenten in stahlungshärtbaren Systemen eingesetzt werden.

Gegenstand der Erfindung sind somit Fotoinitiator-Copolymere mit Molmassen zwischen 500 und 1.000.000, erhältlich durch Copolymerisation von Monomereinheiten der voranstehend definierten Formeln I und II im Verhältnis I/II = 1-100.

Gegenstand der Erfindung ist weiterhin die Verwendung dieser Fotoinitiator-Copolymere als Fotoinitiatoren für die Fotopolymerisation ethylenisch ungesättigter Verbindungen oder solche enthaltender Systeme.

Gegenstand der Erfindung ist darüberhinaus ein Verfahren zur Herstellung fotopolymerisierbarer, ethylenisch ungesättigte Verbindungen enthaltender Systeme, wobei man dem zu polymerisierenden Gemisch mindestens eines dieser Fotoinitiator-Copolymere zusetzt.

Gegenstand der Erfindung sind schließlich polymerisierbare Systeme enthaltend mindestens eine ethylenisch ungesättigte fotopolymerisierbare Verbindung sowie gegebenenfalls weitere bekannte und übliche Zusatzstoffe, die mindestens eines dieser Fotoinitiator-Copolymere enthalten.

Die erfindungsgemäßen Fotoinitiator-Copolymere sind neu. Sie erweisen sich als hochreaktive Fotoinitiatoren, deren spezifische Eigenschaften sich durch die quantitative und qualitative Wahl der Monomereinheiten I und II gezielt einstellen und variieren lassen. Sie sind sehr einfach durch thermische Copolymerisation der entsprechenden Monomerbausteine zugänglich. Aufgrund ihres polymeren Charakters weisen sie eine hohe Migrationsfestigkeit im fotopolymerisierbaren System bzw. im fotopolymerisierten Endprodukt auf.

Die erfindungsgemäßen Fotoinitiator-Copolymere sind aufgebaut aus zumindest zwei voneinander verschiedenen Monomereinheiten der Formeln I und II.

Monomereinheit I enthält einen polymerisierbaren ethylenisch ungesättigten Strukturteil, in den der Rest $R^a$ Wasserstoff, Chlor, Cyano, eine $C_{1-6}$-Alkyl- oder eine Phenylgruppe darstellen kann. Vorzugsweise ist $R^a$ Wasserstoff und somit der ungesättigte Strukturteil eine vinylische Gruppe. Dieser ungesättigte Strukturteil ist entweder direkt über eine Einfachbindung oder über eine Brückengruppierung X mit einer beliebigen Fotoinitiatorgrundstruktur IN verknüpft, wie sie im Prinzip auch in konventionellen Fotoinitiatoren vorliegt.

Die Brückengruppierung X kann eine Carbonyl-, eine Carboxyl-oder ein Alkylengruppe mit 1-10 C-Atomen sein. Sie kann auch eine Carbonyloxyalkylen- oder eine Carbonylpolyoxyethylen-Gruppe mit jeweils 1-10 Methylen- bzw. Oxyethylen-Einheiten sein. Die Verknüpfung mit der Fotoinitiator-Grundstruktur IN kann durch eine Einfachbindung, durch eine Sauerstoff-, Schwefel-, Carbonyl-, Carboxyl- oder Aminogruppe erfolgen. Bevorzugte Verknüpfungen von ungesättigter Struktureinheit mit Fotoinitiatorgrundstruktur IN sind die Einfachbindung, die Carbonyl-, die Carbonyloxymethylenoxy- und die Carbonyloxyethoxygruppe. Im Falle der Verknüpfung durch Einfachbindung resultieren vinylsubstituierte Derivate üblicher Fotoinitiatoren.

In den anderen Fällen der bevorzugten Verknüpfungen resultieren acrylierte Fotoinitiatorderivate.

IN steht im wesentlichen für die aromatische Ketonstruktureinheit bzw. die Thioxanthonstruktureinheit

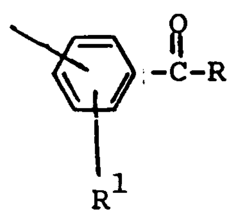

oder

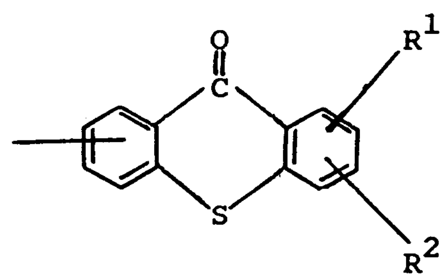

wie sie in den meisten der klassischen Fotoinitiatoren vorliegen, kann aber auch sonstige beliebige Strukturen mit Fotoinitiatoreigenschaften bedeuten.

Steht R für die Gruppierung -$CR^3R^4R^5$, so ergeben sich gemäß den oben angegebenen Definitionen für $R^3$, $R^4$ und $R^5$ die Fotoinitiatorgrundstrukuren der Acyloinether, der Dialkoxyacetophenone, der Hydroxyalkylphenone und Aminoalkylphenone sowie der $\alpha$-Sulfonylketone.

Copolymerisisierbare Hydroxyalkylphenonderivate sind besonders bevorzugte Monomereinheiten der Formel I.

Steht R für die Gruppe

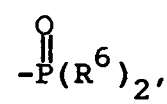

so gehören die resultierenden Fotoinitiatoren zu der Klasse der Acylphosphinoxide.

Copolymerisierbare Thioxanthonderivate sind ebenfalls bevorzugte Monomereinheiten der Formel I.

Zahlreiche ungesättigte Derivate der unterschiedlichsten Fotoinitiatorgruppen, wie sie von Formel I repräsentiert werden, sind bekannt und zum Teil auch kommerziell verfügbar. Dies gilt insbesondere für die in DE-OS 35 34 645 und EP-OS 161463 beschriebenen Hydroxyalkylphenon-Derivate sowie die entsprechenden ungesättigt funktionalisierten Fotoinitiatoren der deutschen Patentanmeldungen P 37 07 891 und P 37 38 567. Sie sind im Prinzip nach Standardverfahren der organischen Chemie herstellbar.

Die Reaktionsbedingungen hierbei können den Standardwerken der präparativen organischen Chemie entnommen werden, z.B. HOUBEN-WEYL, Methoden der organischen Chemie, Georg-Thieme Verlag, Stuttgart, oder ORGANIC SYNTHESIS, J. Wiley, New York London Sydney.

Generell ist es günstig, die Comonomere der Formel I oder entsprechende Vorstufen nach den bewährten Synthesemethoden, wie sie für die zugrundeliegenden Fotoinitiatoren gängig sind, herzustellen. Hierbei ist es vorteilhaft, gleich von den bekannten Fotoinitiatoren als Ausgangssubstanzen auszugehen und an diese mit gängigen Reaktionen, wie Substitutionsreaktionen, in ein oder mehreren Schritten die ungesättigte Struktureinheit anzuknüpfen. Es können aber auch schon geeignet substituierte Vorstufen der bekannten Fotoinitiatoren genommen werden und in diesen erst, wenn der ungesättigte Strukturteil schon vorliegt, die eigentliche Fotoinitiator-Wirkstruktur erzeugt werden.

Besonders geeignet als Vorstufen für ungesättigt funktionalisierte Fotoinitiatoren sind zahlreiche der in den deutschen Patentanmeldungen P 37 07 891 und P 37 38 567 beschriebenen Fotoinitiatorderivate, die reaktionsfähige funktionelle Gruppen aufweisende Substituenten tragen.

Bevorzugt sind hiervon die Hydroxyethoxy- und Hydroxyethylthio-substituierten Fotoinitiatorderivate, da diese sich leicht in die entsprechenden (Meth)Acrylsäureester überführen lassen. Typische ungesättigt funktionalisierte Fotoinitiatorderivate, die als Monomerbausteine der Formel I für die erfindungsgemäßen Fotoinitiator-Copolymere dienen können, sind etwa

(4-Vinylphenyl)-2-hydroxy-2-propylketon (Ia)
(4-Allyloxyphenyl)-2-hydroxy-2-propylketon (Ib)
[4-(2-Allyloxyethoxy)phenyl]-2-hydroxy-2-propylketon (Ic)
4-(2-Hydroxy-2-methylpropionyl)phenoxyessigsäurevinylester (Id)
(4-Acryloyloxyphenyl)-2-hydroxy-2-propylketon (Ie)
(4-Methacryloyloxyphenyl)-2-hydroxy-2-propylketon (If)

[4-(2-Acryloyloxyethoxy)-phenyl]-2-hydroxy-2-propylketon (Ig)
[4-(2-Methacryloyloxyethoxy)phenyl]-2-hydroxy-2-propylketon (Ih)
[4-(2-Acryloyloxydiethoxy)-phenyl]-2-hydroxy-2-propylketon (Ii)
[4-(2-Acryloyloxyethyl)-thiophenyl]-2-hydroxy-2-propylketon (Ij)
[4-(2-Acryloyloxyethylthio)phenyl]-2-(N-morpholino)-2-propylketon (Ik)
2-[2-(Acryloyloxy)ethylthio]thioxanthon (Il)
2-[2-(Acryloylamino)ethylthio]thioxanthon (Im)
2-[2-(Allyloxy)ethylthio]thioxanthon (In)
2-[2-(Allylamino)ethylthio]thioxanthon (Io)
4-[2-(Methacryloyloxy)ethoxycarbonyl]thioxanthon (Ip)

Die Monomereinheit der Formel II ist völlig analog zur Monomereinheit der Formel I aufgebaut. Die hierin mit der ungesättigten Struktureinheit direkt oder über die Brückengruppierung X verknüpfte Gruppe A kann eine wie voranstehend bereits definierte Fotoinitiatorgrundstruktur IN sein, sie kann aber auch Wasserstoff, $C_{1-12}$-Alkyl, $C_{1-12}$-Alkenyl, Phenyl, Styryl, Halogen, wie insbesondere Chlor und Fluor, die Isocyanat-, Isothiocyanat-, Azid-, Sulfonsäure-, Sulfonylchloridgruppe, eine Vinyl- oder Oxiranylgruppe, die gegebenenfalls auch ein-oder mehrfach mit Chlor oder Methyl substituiert sein kann oder eine Silylgruppe, in der die am Silicium gebundenen Reste Chlor und/oder $C_{1-12}$-Alkyl und/oder $C_{1-12}$-Alkoxy und/oder $C_{1-12}$-Alkanoyloxy bedeuten, sein.

Ungesättigte Monomereinheiten der Formel II, die keine fotoinitiierend wirkende Strukturteile IN enthalten, sind in großer Vielfalt aus dem Bereich der Polymerchemie bekannt und verfügbar. Vorwiegend handelt es sich hierbei um Vinyl- und Acrylderivate, also übliche einfach und günstig zugängliche ungesättigte Monomerbausteine.

Bevorzugte derartige Monomerbausteine sind insbesonder solche, die funktionelle, zu weiteren Reaktionen befähigte Gruppen aufweisen, wie insbesonder Hydroxy-, Carboxy-, Carbonsäureamid-, Sulfonsäure-, Isocyanat-, olefinisch ungesättigte und Silylgruppen. Durch derartige funktionalisierte Monomerbausteine können erfindungsgemäße Fotoinitiator-Copolymere mit gezielten, für den jeweiligen Einsatz maßgeschneiderten Eigenschaften hergestellt werden. So kann Kompatibilität mit unterschiedlichsten strahlungshärtbaren Systemen und insbesondere auch mit Hybridbindemittelsystemen erreicht werden. Die funktionellen Gruppen befähigen die erfindungsgemäßen Fotoinitiator-Copolymere zu Coreaktivität im Sinne von P 37 07 891/P 37 38 567, d.h. also insbesondere zu Reaktionen mit Bestandteilen der strahlungshärtbaren Systeme oder mit dem Substrat.

Typische derartige Monomereinheiten der Formel II sind etwa (Meth)Acrylsäure, (Meth)Acrylamid, (Meth)Acrylsäurealkylester, Hydroxyethylmethacrylat, (Meth)Acrylsäure-Alkenyl- oder Epoxyester, Hexandioldiacrylat, Acrylnitril, Styrol, Divinylbenzol, Methylvinylketon, N-Vinylpyrrolidon, 2-(N,N-Dimethylamino)-ethylmethacrylat, 3-(Trimethoxysilyl)propylmethacrylat.

Im Falle von initiatorgruppenhaltigen Monomerbausteinen der Formel II sind ebenfalls jene bevorzugt, die für die Monomereinheiten der Formel I als bevorzugt angegeben sind. Werden die erfindungsgemäßen Fotoinitiator-Copolymere jeweils nur aus initiatorhaltigen Monomeren aufgebaut, so sind die Monomereinheiten der Formel I und der Formel II voneinander verschieden.

Die Herstellung der erfindungsgemäßen Fotoinitiator-Copolymeren aus den Monomereinheiten der Formeln I und II erfolgt in an sich bekannter Weise für die Polymerisation derartiger olefinisch ungesättigter Verbindungen, nämlich in Lösung mit Hilfe von üblichen thermisch aktivierbaren Radikalstartern, wie etwa Benzoylperoxid oder Azobisisobutyronitril unter Ausschluß von Lichteinwirkung. Die Monomereinheiten der Formeln I und II werden dabei mengenmäßig so eingesetzt, daß das Verhältnis von I zu II zwischen 1 und 100, vorzugsweise zwischen 2 und 10, liegt. Typische Lösungsmittel für die Polymerisation sind etwa Tetrahydrofuran und Toluol. Die Umsetzung erfolgt normalerweise bei Rückflußtemperatur des Lösungsmittels. Die Isolierung der Fotoinitiator-Copolymere erfolgt durch Fällung mit einem Nichtlösungsmittel, beispielsweise n-Hexan. Durch gegebenenfalls wiederholtes Umfällen können die Fotoinitiator-Copolymere aufgereinigt werden. Die erhaltenen Produkte. lassen sich, wie für Polymerprodukte üblich, durch ihre gelpermeationschromatografisch bestimmbare mittlere Molmasse $\overline{M}w$ und ihre differentialthermoanalytisch bestimmbare Glasübergangstemperatur Tg ausreichend charakterisieren. Es wird eine statistische Verteilung der unterschiedlichen Monomereinheiten im Copolymer angenommen. Die mittlere Molmasse kann zwischen 500 und 1.000.000 liegen und ist vorzugsweise zwischen 1000 und 10.000.

Die erfindungsgemäßen Fotoinitiator-Copolymere können sehr vorteilhaft als mit maßgeschneiderten zusätzlichen Eigenschaften ausgestattete Fotoinitiatoren für die Fotopolymerisation ethylenisch ungesättigter Verbindungen bzw. solche enthaltender Systeme eingesetzt werden. Vornehmlich dienen sie analog zu konventionellen Fotoinitiatoren als UV-Härter für Lack- oder Polymerbeschichtungen, UV-härtbare Bindemittel- und Hybridbindemittelsysteme, Druckfarben und bei der Strahlungshärtung wässriger Präpolymerdispersionen. Die Anwendung erfolgt in üblicher Weise, wobei sie den zu polymerisierenden Systemen in der Regel in Mengen von 0,1-20 Gew.%, vorzugsweise 0,5-12 Gew.% zugesetzt werden. Dieser Zusatz geschieht in der Regel durch einfaches Einrühren in die zu polymerisierenden Systeme.

Die erfindungsgemäßen Fotoinitiator -Copolymere können in vielen Fällen auch selbst als alleiniger oder als wesentlicher Bestandteil von strahlungshärtbaren Systemen genommen werden. Sie übernehmen dann gleichzeitig sowohl die schichtbildende und die fotoinitiierende Funktion. So lassen sich beispielsweise Copolymere von [4-(2-Acryloyloxyethoxy)phenyl]-2-hydroxy-2-propylketon (Ig) mit 2-Dimethylaminoethylmethacrylat oder 3-(Trimethoxysilyl)propylmethacrylat, als Schicht auf ein Substrat aufgebracht, vorzüglich mit UV-Strahlung photostrukturieren. Diese Materialien sind somit gut als Negativ-Fotoresists einsetzbar.

Mit Hilfe der erfindungsgemäßen Fotoinitiator-Copolymere lassen sich auch Polymermaterialien, die selbst nicht fotovernetzbar bzw. fotostrukturierbar sind, weil sie etwa keine ethylenisch ungesättigten Doppelbindungen enthalten, fotoreaktiv machen.

Es ist bekannt, daß sich die Wirkung von zahlreichen konventionellen Fotoinitiatoren im Gemisch mit anders strukturierten Fotoinitiatoren, also Coinitiatoren und/oder Sensibilisatoren, wie insbesondere organischen Aminen, zum Teil erheblich steigern läßt. Typisch hierfür sind etwa Gemische von Hydroxyalkylphenonen mit Thioxanthonen sowie gegebenenfalls Aminoverbindungen, wie etwa N-Methyldiethanolamin.

In der Kombination von Initiatoren mit Coinitiatoren bzw. Sensibilisatoren in den erfindungsgemäßen Fotoinitiator-Copolymeren liegt ein besonders bevorzugter Aspekt der Erfindung. Es hat sich nämlich überraschend gezeigt, daß derartige Fotoinitiator-Copolymere wirksamer sind als Gemische der zugrundliegenden konventionellen Fotoinitiatoren, Coinitiatoren und Sensibilisatoren.

So erweisen sich beispielsweise Copolymere aus dem ungesättigten Hydroxyalkylphenonderivat Ig und dem ungesättigten Thioxanthonderivat Im überraschenderweise deutlich wirksamer als das entsprechende Gemisch der konventionellen Hydroxyalkylphenon- und Thioxanthon-Fotoinitiatoren. Eine Erklärung hierfür könnte in einer unmittelbaren coinitiierenden Wechselwirkung der unterschiedlichen Initiatorgruppen, bedingt durch die Fixierung im Copolymerverband, gesehen werden.

Fotoinitiator-Copolymere können sehr vorteilhaft auch als diskrete Fotoinitiatorschicht auf das Substratmaterial aufgebracht und dann erst mit einem fotopolymerisierbaren Schichtmaterial versehen werden. Die Anwendung in Form derartiger Zweischichtensysteme erfolgt im Sinne von DE-OS 36 29 543 und DE-OS 37 02 897. Besonders vorteilhaft sind hierbei Fotoinitiator-Copolymere mit polaren, gegebenenfalls chelatbildenden Gruppen sowie mit Silylgruppen. Hierdurch wird eine bessere Fixierung auf Metall-, Halbleiter-, Glas- und Keramiksubstraten erreicht.

Copolymere mit Aminogruppen-haltigen Monomerbausteinen der Formel II, beispielsweise mit 2-(N,N-Dimethylamino)ethylmethacrylat, enthalten in sich den vielfach vorteilhaften Aminbeschleuniger und sind reaktiver als die entsprechenden konventionellen Systeme.

In solche Aminogruppen-haltige Fotoinitiator-Copolymere lassen sich während der Herstellung Farbstoffe, die mit Aminogruppen Salze bilden können, inkorporieren. Geeignet sind beispielsweise Xanthen-Farbstoffe wie etwa Bengalrosa. Überraschend verschiebt sich hierdurch das Absorptionsmaximum in den längerwelligen Bereich, so daß derartig modifizierte Fotoinitiator-Copolymere auch mit längerwelliger Strahlung, etwa zwischen 500 und 600 nm aktivierbar werden.

Generell weisen die erfindungsgemäßen Fotoinitiator-Copolymere aufgrund ihres hochmolekularen Charakters eine ausgezeichnete Migrationsfestigkeit auf. Das bedeutet, sie wandern nicht in oder aus:den entsprechenden strahlungshärtbaren Systemen, was für zahlreiche Anwendungen besonders wichtig ist.

Unter einem zu polymerisierenden System wird ein Gemisch von durch freie Radikale initiierbaren mono- oder polyfunktionellen ethylenisch ungesättigten Monomeren, Oligomeren, Prepolymeren, Polymeren oder Mischungen dieser Oligomeren, Prepolymeren und Polymeren mit ungesättigten Monomeren verstanden, das, falls erforderlich oder erwünscht, weitere Zusätze wie z. B. Antioxidantien, Lichtstabilisatoren, Farbstoffe, Pigmente, aber auch weitere bekannte Fotoinitiatoren sowie Reaktionsbeschleuniger enthalten kann. Als ungesättigte Verbindungen kommen alle diejenigen infrage, deren C = C-Doppelbindungen durch z. B. Halogenatome, Carbonyl-, Cyano-, Carboxy-, Ester-, Amid-, Ether- oder Arylgruppen oder durch konjugierte weitere Doppel- oder Dreifachbindungen aktiviert sind. Beispiele für solche Verbindungen sind Vinylchlorid, Vinylidenchlorid, Acrylnitril, Methacrylnitril, Acrylamid, Methacrylamid, Methyl-, Ethyl-, n-oder tert. Butyl-, Cyclohexyl-, 2-Ethylhexyl-, Benzyl-, Phenyloxyethyl-, Hydroxyethyl-, Hydroxypropyl-, niederes Alkoxyethyl-, Tetrahydrofurfurylacrylat oder -methacrylat, Vinylacetat, -propionat, -acrylat, -succinat, N-Vinylpyrrolidon, N-Vinylcarbazol, Styrol, Divinylbenzol, substituierte Styrole, sowie die Mischungen von solchen ungesättigten Verbindungen. Auch mehrfach ungesättigte Verbindungen wie beispielsweise Ethylendiacrylat, 1,6-Hexandioldiacrylat, propoxyliertes Bisphenol-A-diacrylat und -dimethacrylat, Trimethylolpropandiacrylat und Pentaerythrittriacrylat können mit den erfindungsgemäß verwendeten Fotoinitiatoren polymerisiert werden. Als fotopolymerisierbare Verbindungen kommen weiterhin ungesättigte Oligomere,

Prepolymere oder Polymere und deren Mischungen mit ungesättigten Monomeren in Frage. Hierzu zählen beispielsweise ungesättigte Polyester, ungesättigte Acrylmaterialien, Epoximaterialien, Urethane, Silikone, Aminopolyamid-Harze und insbesondere acrylierte Harze wie acryliertes Silikonöl, acrylierte Polyester, acrylierte Urethane, acrylierte Polyamide, acryliertes Sojabohnenöl, acryliertes Epoxiharz, acryliertes Acrylharz, zweckmäßig im Gemisch mit einem oder mehreren Acrylaten eines Mono-, Di- oder Polyalkohols.

Der Ausdruck "Fotopolymerisation von ethylenisch ungesättigten Verbindungen" ist im weitesten Sinn zu verstehen. Darunter fällt z. B. auch das weitere Polymerisieren oder das Quervernetzen von polymeren Materialien, etwa von Prepolymeren, die Homo-, Co- und Terpolymerisation von einfachen Monomeren und auch die Kombination der genannten Reaktionsarten.

Durch die Einwirkung von energiereicher Strahlung, vorzugsweise UV-Licht, auf die die erfindungsgemäßen Fotoinitiator-Copolymere enthaltenden fotopolymerisierbaren Systemen kann die Fotopolymerisation ausgelöst werden.

Die Fotopolymerisation erfolgt nach an sich bekannten Methoden durch Bestrahlen mit Licht oder UV-Strahlung des Wellenlängenbereichs von 250-500 nm, vorzugsweise von 300-400 nm. Als Strahlenquellen können Sonnenlicht oder künstliche Strahler verwendet werden. Vorteilhaft sind zum Beispiel Quecksilberdampf-Hochdruck-, -Mitteldruck- oder -Niederdrucklampen sowie Xenon- und Wolframlampen.

Die Durchführung der Fotopolymerisation unter Verwendung der erfindungsgemäßen Fotoinitiator-Copolymere kann sowohl diskontinuierlich als auch kontinuierlich geschehen. Die Bestrahlungsdauer hängt von der Art der Durchführung, von der Art und Menge der eingesetzten polymerisierbaren Materialien, von Art und Konzentration der verwendeten Fotoinitiatoren und von der Intensität der Lichtquelle ab und kann, wie beispielsweise bei der Strahlungshärtung von Beschichtungen, im Bereich weniger Sekunden bis Minuten, bei Großansätzen, wie beispielsweise bei der Massepolymerisation, aber auch im Stundenbereich liegen.

Die erfindungsgemäßen Fotoinitiator-Copolymere werden bevorzugt verwendet als Fotoinitiatoren bei der UV-Härtung von dünnen Schichten wie beispielsweise Lackbeschichtungen auf allen hierfür üblichen Materialien und Trägern. Diese können vornehmlich sein Papier, Holz, textile Träger, Kunststoff und Metall. Ein wichtiges Anwendungsgebiet ist auch die Trocknung bzw. Härtung von Druckfarben und Siebdruckmaterialien, von denen letztere bevorzugt bei der Oberflächenbeschichtung bzw. -gestaltung von beispielsweise Dosen, Tuben und metallenen Verschlußkappen eingesetzt werden. Aufgrund der weitestgehenden bis völligen Abwesenheit freier Initiatorreste oder freier Fotolyseprodukte in mit den erfindungsgemäßen Fotoinitiator-Copolymeren versetzten Systemen nach erfolgter Fotopolymerisation sind diese besonders geeignet in Anwendungsgebieten, wo eine Diffusion derartiger Reste in entsprechende Endprodukte umgebende Medien ausgeschlossen werden soll, beispielsweise wenn mit fotopolymerisierten Beschichtungen versehene Verpackungsmittel mit Lebensmitteln in Berührung kommen.

## Beispiele

A. Herstellung von Fotoinitiator-Copolymeren

Allgemeine Herstellungsvorschrift:

Die monomeren Ausgangsprodukte werden in den entsprechenden molaren Mengen in THF (150-300 ml/Ansatz bis zu 100 mMol) gelöst und mit Azobisisobutyronitril (150-300 mg/Ansatz bis zu 100 mMol) versetzt. Es wird 12 Stunden unter Rückfluß erhitzt. Danach wird das Lösungsmittel abgezogen, der Rückstand in Essigester aufgenommen, die Lösung mit Aktivkohle versetzt und filtriert. Durch Fällen mit n-Hexan und Umfällen aus Essigester/n-Hexan erhält man das Fotoinitiator-Copolymer.

Verwendete Fotoinitiator-Monomere:

[4-(2-Acryloyloxyethoxy)phenyl]-2-hydroxy-2-propylketon (Ig)
[4-(2-Methacryloyloxyethoxy)phenyl]-2-hydroxy-2-propylketon (Ih)
[4-(2-Acryloyloxyethylthio)phenyl]-2-(N-morpholino)-2-propylketon (Ik)
2-[2-(Acryloyloxy)ethylthio]thioxanthon (Il)
4-[2-(Methacryloyloxy)ethoxycarbonyl]thioxanthon (Ip)

Hergestellte Fotoinitator-Copolymere:

| Beispiel Nr. | Monomere / | molarer Mengenanteil | Mw | Tg (°C) |
|---|---|---|---|---|
| 1 | Ig<br>Il | 10<br>1 | 3000 | - |
| 2 | Ig<br>Il | 1<br>1 | 3200 | 37,7 |
| 3 | Ik<br>Il | 5<br>1 | 1900 | 47,4 |
| 4 | Ik<br>Il | 10<br>1 | 1900 | 47,9 |
| 5 | Ik<br>Il | 15<br>1 | 1950 | 40,8 |
| 6 | Ik<br>Ip | 10<br>1 | 4100 | 38,5 |
| 7 | Ik<br>Ip<br>Acrylsäure | 10<br>1<br>2 | 3000 | 32,7 |
| 8 | Ik<br>Ip<br>Acrylsäure | 10<br>1<br>5 | 3050 | 35,3 |

| Beispiel Nr. | Monomere / | molarer Mengenanteil | Mw | Tg (°C) |
|---|---|---|---|---|
| 9* | Ig<br>2-Dimethylamino-ethylmethacrylat<br>Bengalrosa (0,5 g/100 mMol-Ansatz) | 3<br>1 | 3450 | 36,5 |
| 10 | Ih<br>Methylmethacrylat | 6<br>1 | 2200 | 107 |
| 11 | Ih<br>Methylmethacrylat | 1<br>1 | 2300 | 90,2 |
| 12 | Ig<br>n-Dodecylacrylat | 10<br>1 | 3400 | 28,3 |
| 13 | Ig<br>Acrylsäure | 5<br>1 | 3300 | 35,9 |
| 14 | Ig<br>Acrylamid | 10<br>1 | 3000 | 45,3 |
| 15 | Ig<br>Acrylamid | 1<br>1 | 2300 | 62,9 |
| 16 | Ig<br>3-(Trimethoxysilyl)-propylmethacrylat | 3<br>1 | 3100 | (Öl) |
| 17 | Ig<br>3-(Trimethoxysilyl)-propylmethacrylat | 6<br>1 | 3100 | (Öl) |

* Maximale Absorption bei λ = 550 nm

B. Anwendungstechnische Vergleichsversuche

In Proben eines pigmentierten strahlungshärtbaren Bindemittelsystems, bestehend aus

75 Gewichtsteile Polyesteracrylat (Laromer EA 81, Fa. BASF)
25 Gewichtsteile Hexandioldiacrylat
30 Gewichtsteile $TiO_2$

wurden die zu testenden erfindungsgemäßen Fotoinitiator-Copolymere und entsprechende konventionelle Fotoinitiatoren bzw. Fotoinitiatorgemische zum Vergleich eingerührt.

Die initiatorhaltigen Systeme wurden auf Glasplatten (10 x 10 cm) in einer Schichtdicke von 24 µm appliziert.

Die UV-Härtung erfolgte dann, indem die beschichteten Platten auf einem Transportband variabler Geschwindigkeit unter Hg-Mitteldrucklampen (Lampenleistung 2 x 80 W/cm; Lampenabstand 10 cm) vorbeigeführt wurden.

Als Maß für das jeweilige Härtungsergebnis bei unterschiedlichen Bandgeschwindigkeiten wurde nach 20 Stunden Lagerung die Pendelhärte nach König (DIN 53157) bestimmt.

| Pendelhärte (Sekunden) | Bandgeschwindigkeit (m/min) | | | |
|---|---|---|---|---|
| | 5 | 10 | 15 | 20 |
| Initiator/Gehalt⁺ | | | | |
| Bspl.-Nr. 1 / 3 Gew.% | 124 | 83 | 71 | 58 |
| Bspl.-Nr. 2 / 3 Gew.% | 133 | 95 | 81 | 62 |
| Vergleich ‡ / 3 Gew.% | 92 | 66 | 53 | 41 |

⁺ zusätzlich in allen Fällen 2 Gew.% N-Methyldiethanolamin
‡ Gemisch aus Phenyl-2-hydroxy-2-propylketon und 2-Isopropylthioxanthon/9:1 (Darocur 1664, Fa. E. Merck)

Die erfindungsgemäßen Fotoinitiator-Copolymere, also Copolymere, die Hydroxyalkylphenon- und Thioxanthon-Einheiten enthalten, zeigen ein erheblich besseres Härtungsergebnis im Vergleich zu Gemischen entsprechender zugrundeliegender Fotoinitiatoren.

C. Anwendungsbeispiele / Fotostrukturierung

Eine 10 %ige Lösung des Copolymer gemäß Bspl.-Nr. 9 in Diethylenglycoldimethylether wurde auf eine Glasplatte (5 x 5 cm) aufgeschleudert (30 Sek., 4500 Upm). Die beschichtete Platte wurde 10 min bei 150 °C getrocknet. Die zur Hälfte abgedeckte Platte wurde 4 min mit einer UV-Lampe (Typ TQ 180, Fa. Heraeus Original Hanau) im Abstand von 5 cm bestrahlt. Nach der Bestrahlung wurde mit Aceton behandelt, wobei sich der nicht belichtete Teil der Beschichtung ablöste. Im belichteten Bereich verblieb eine gut haftende, auch bei längerer Lagerung in Aceton unveränderte, gehärtete Beschichtung von 0,4 µm Dicke. Ein analoges Ergebnis wurde erzielt mit dem Copolymer gemäß Bspl.-Nr. 16.

Ein analoges Ergebnis wurde erzielt mit einem Copolymer aus Monomer Ig, 3-(Trimethoxysilyl)-propylmethacrylat und Methylmethacrylat im Molverhältnis 3:1:5.

## Patentansprüche

1. Fotoinitiator-Copolymere mit Molmassen zwischen 500 und 1.000.000, erhältlich durch Copolymerisation von zumindest zwei unterschiedlichen Monomereinheiten der Formeln I und II im Verhältnis I/II = 1-100

$$(I)\qquad CH_2 = \overset{\displaystyle R^a}{\overset{|}{C}}-(X)_{0,1}\ IN$$

$$(II)\qquad CH_2 = \overset{\displaystyle R^b}{\overset{|}{C}}-(X)_{0,1}\ A$$

worin bedeutet

- $R^a$, $R^b$ jeweils unabhängig voneinander H, Cl, CN, $C_{1-6}$-Alkyl oder Phenyl,
- X CO-, COO-, O-CO-, $(CH_2)_nY$, $COO(CH_2)_nY$, $CO(OCH_2CH_2)_nY$ mit n = 1-10 und Y eine eine Einfachbindung, -O-, -S-, -CO-, -COO-, -OCO-, -NH-, -N($C_{1-6}$-Alkyl)-,
- IN eine der Fotoinitiatorgrundstrukturen

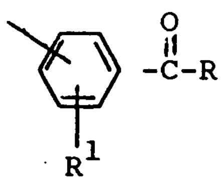 oder 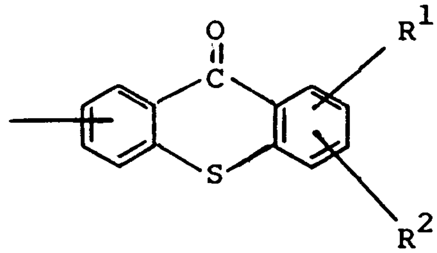

worin

- R $-CR^3R^4R^5$ oder

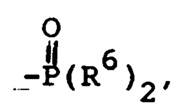

und

- $R^1$, $R^2$ H, Halogen, $C_{1-12}$-Alkyl oder $C_{1-12}$-Alkoxy,
- $R^3$, $R^4$ jeweils unabhängig voneinander H, $C_{1-12}$-Alkyl, $C_{1-12}$-Alkenyl, $C_{1-12}$-Alkoxy oder zusammen $C_{2-6}$-Alkylen,
- $R^5$ -OH, $C_{1-6}$-Alkoxy, $C_{1-6}$-Alkanoyloxy, -N($C_{1-6}$-Alkyl)$_2$,

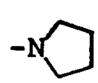 , 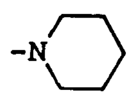, 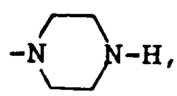,

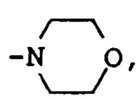,

$-SO_2R^7$, $-OSO_2R^7$,

- $R^6$ $C_{1-6}$-Alkyl, $C_{1-6}$-Alkanoyl, Phenyl oder Benzoyl, jeweils gegebenenfalls mit Halogen,

$C_{1-6}$-Alkyl oder $C_{1-6}$-Alkoxy substituiert

$R^7$ $C_{1-6}$-Alkyl, Phenyl

darstellt,

A eine der Fotoinitiatorgrundstrukturen IN mit den oben angegebenen Bedeutungen oder H, $C_{1-12}$-Alkyl, $C_{1-12}$-Alkenyl, Phenyl, Styryl, Halogen, NCO, NCS, $N_3$, $SO_3H$, $SO_2Cl$, $CR^c=CR^dR^e$ oder

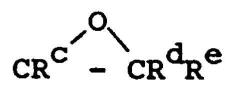

mit $R^c$, $R^d$, $R^e$ jeweils H oder $CH_3$, $SiR^fR^gR^h$ mit $R^f$, $R^g$, $R^h$ jeweils Cl, $C_{1-12}$-Alkyl, -Alkoxy, -Alkanoyloxy.

**2.** Verwendung von Copolymeren nach Anspruch 1 als Fotoinitiatoren für die Fotopolymerisation ethylenisch ungesättigter Verbindungen oder solche enthaltender Systeme.

**3.** Verfahren zur Herstellung fotopolymerisierbare ethylenisch ungesättigte Verbindungen enthaltender Systeme, dadurch gekennzeichnet, daß man dem zu polymerisierenden Gemisch mindestens ein Fotoinitiator-Copolymer nach Anspruch 1 zusetzt.

**4.** Verfahren nach Anspruch 3, dadurch gekennzeichnet, daß man dem zu polymerisierenden Gemisch 0,1 bis 20 Gew.% eines Fotoinitiator-Copolymer nach Anspruch 1 zusetzt.

**5.** Fotopolymerisierbare Systeme, enthaltend mindestens eine ethylenisch ungesättigte fotopolymerisierbare Verbindung sowie gegebenenfalls weitere bekannte und übliche Zusatzstoffe, dadurch gekennzeichnet, daß sie mindestens ein Fotoinitiator-Copolymer nach Anspruch 1 enthalten.

**6.** Verwendung von Copolymeren nach Anspruch 1 als gleichzeitig fotoinitiierend wirkende und schichtbildende Komponente in strahlungshärtbaren Systemen.

**7.** Strahlungshärtbare Systeme bestehen im wesentlichen aus ein oder mehreren Copolymeren nach Anspruch 1.

**8.** Verfahren zur Herstellung einer strahlungsgehärteten Beschichtung auf einem Substrat, wobei man dieses mit einem fotopolymerisierbaren System beschichtet und die Härtung durch Bestrahlen mit UV-Licht einer Wellenlänge zwischen 250 und 600 nm vornimmt, dadurch gekennzeichnet, daß ein System nach Anspruch 5 oder 7 verwendet wird.

## Claims

**1.** A photoinitiator copolymer having a molecular weight between 500 and 1,000,000, obtainable by copolymerization of at least two different monomer units of the formulae I and II in the I/II ratio = 1-100

$$(I) \qquad CH_2 = \overset{\overset{\displaystyle R^a}{|}}{C}-(X)_{0,1}\ IN$$

$$(II) \qquad CH_2 = \overset{\overset{\displaystyle R^b}{|}}{C}-(X)_{0,1}\ A$$

in which

$R^a$ and $R^b$, independently of one another, are each H, Cl, CN, $C_{1-6}$alkyl or phenyl

X is CO-, COO-, O-CO-, $(CH_2)_nY$, $COO(CH_2)_nY$, $CO(OCH_2CH_2)_nY$ where n = 1-10 and Y is a single bond, -O-, -S-, -CO-, -COO-, -OCO-, -NH- or -N($C_{1-6}$alkyl)-,

IN is one of the basic photoinitiator structures

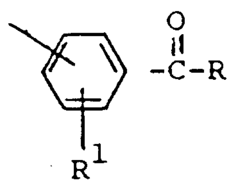

or

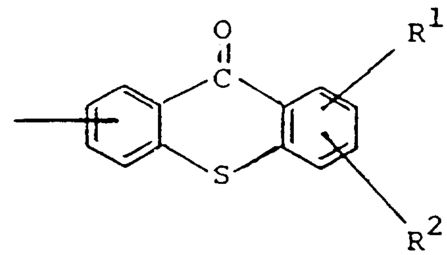

in which

R is $-CR^3R^4R^5$ or

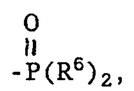

and

$R^1$ and $R^2$ are H, halogen, $C_{1-12}$alkyl or $C_{1-12}$alkoxy,

$R^3$ and $R^4$ independently of one another, are each H, $C_{1-12}$alkyl, $C_{1-12}$alkenyl, $C_{1-12}$alkoxy or together are $C_{2-6}$alkylene,

$R^5$ is -OH, $C_{1-6}$alkoxy, $C_{1-6}$alkanoyloxy, $-N(C_{1-6}alkyl)_2$,

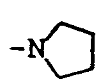 , 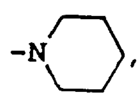, 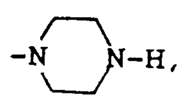,

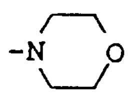,

$-SO_2R^7$ or $-OSO_2R^7$

$R^6$ is $C_{1-6}$alkyl, $C_{1-6}$alkanoyl, phenyl or benzoyl, in each case optionally substituted by halogen, $C_{1-6}$alkyl or $C_{1-6}$alkoxy,

$R^7$ is $C_{1-6}$alkyl or phenyl,

A is one of the basic photoinitiator structures IN as defined above, or H, $C_{1-12}$alkyl, $C_{1-12}$alkenyl, phenyl, styryl, halogen, NCO, NCS, $N_3$, $SO_3H$, $SO_2Cl$, $CR^c=CR^dR^e$ or

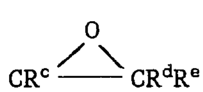

where $R^c$, $R^d$ and $R^e$ are each H or $CH_3$, or is $SiR^fR^gR^h$ where $R^f$, $R^g$ and $R^h$ are each Cl, $C_{1-12}$alkyl, $C_{1-12}$alkoxy or $C_{1-12}$alkanoyloxy.

**2.** The use of a copolymer according to claim 1 as a photoinitiator for the photopolymerization of ethylenically unsaturated compounds or systems containing such compounds.

**3.** A process for the preparation of photopolymerizable systems containing ethylenically unsaturated compounds, characterized in that at least one photoinitiator copolymer according to claim 1 is added to the mixture to be polymerized.

4. A process according to claim 3, characterized in that 0.1 to 20% by weight of a photoinitiator copolymer according to claim 1 are added to the mixture to be polymerized.

5. A photopolymerizable system containing at least one ethylenically unsaturated, photopolymerizable compound and, if appropriate, further known and customary additives, characterized in that they contain at least one photoinitiator copolymer according to claim 1.

6. The use of a copolymer according to claim 1 as a simultaneously photoinitiating and film-forming component in radiationcurable systems.

7. A radiation-curable system essentially comprising one or more copolymers according to claim 1.

8. A process for the preparation of a radiation-cured coating on a substrate, the latter being coated with a photopolymerizable system and the curing being carried out by irradiation with UV light of a wavelength between 250 and 600 nm, characterized in that a system according to claim 5 or 7 is used.

**Revendications**

1. Copolymères photo-initiateurs ou photo-amorceurs d'un poids moléculaire compris entre 500 et 1.000.000 que l'on peut obtenir par copolymérisation d'au moins deux unités monomères différentes de formules I et II dans un rapport I/II = 1-100

(I) 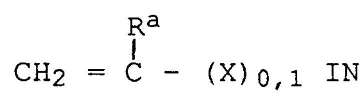

(II) 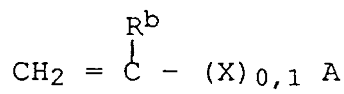

dans laquelle signifient

- $R^a$, $R^b$ chacun indépendamment l'un de l'autre H, Cl, CN, un alkyle en $C_{1-6}$ ou le phényle,
- X CO-, COO-, O-CO-, $(CH_2)_nY$, $COO(CH_2)nY$, $CO(OCH_2CH_2)_nY$ avec n = 1-10 et Y une liaison simple, -O-, -S-, -CO, -COO-, -OCO-, -NH-, -N(alkyl en $C_{1-6}$),
- IN l'une des structure de base des photo-amorceurs

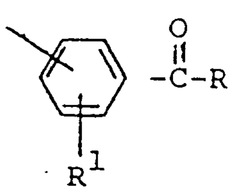

ou

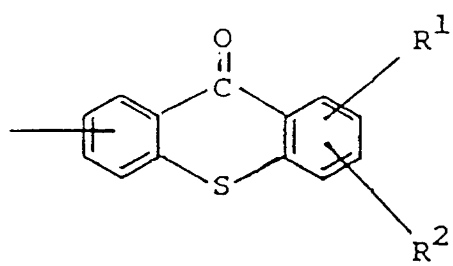

dans laquelle R représente :

$-CR^3R^4R^5$ ou

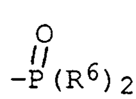

et

$R^1$, $R^2$ représentent H, un halogène, un alkyle en $C_{1-12}$ ou un alcoxy en $C_{1-12}$,

$R^3$, $R^4$ chacun indépendamment l'un de l'autre représente H, un alkyle en $C_{1-12}$, un alcényle en $C_{1-12}$, un alcoxy en $C_{1-12}$ ou ensemble un alkylène en $C_{2-6}$,

$R^5$ représente -OH, un alcoxy en $C_{1-6}$, un alcanoyloxy en $C_{1-6}$, un -N(alkyl en $C_{1-6}$)$_2$

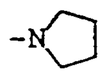 , 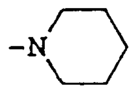 , 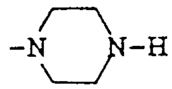 ,

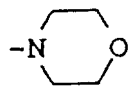 ,

$-SO_2R^7$, $-OSO_2R^7$,

$R^6$ représente un alkyle en $C_{1-6}$, un alcanoyle en $C_{1-6}$, le phényle ou le benzoyle, chaque fois éventuellement substitué par un halogène, par un alkyle en $C_{1-6}$ ou par un alcoxy en $C_{1-6}$

$R^7$ représente un alkyle en $C_{1-6}$, le phényle,

A représente une des structures de base du photoamorceur IN avec les significations données ci-dessus
ou H, un alkyle en $C_{1-12}$, un alcényle en $C_{1-12}$, le phényle, le styryle, un halogène, NCO, NCS, $N_3$, $SO_3H$, $SO_2Cl$,
$CR^c = CR^dR^e$ ou

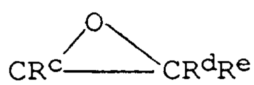

avec $R^c$, $R^d$, $R^e$ chaque fois H ou $CH_3$, $SiR^fR^gR^h$ avec $R^f$, $R^g$, $R^h$ chaque fois Cl, un alkyle en $C_{1-12}$, un alcoxy en $C_{1-12}$, un alcanoyloxy en $C_{1-12}$.

**2.** Utilisation des copolymères selon la revendication 1 en tant que photo-amorceurs pour la photopolymérisation de composés à insaturation éthylènique ou de systèmes contenant de tels composés.

**3.** Procédé pour la préparation de systèmes contenant des composés photopolymérisables à insaturation éthylènique caractérisé en ce qu'on ajoute au mélange à polymériser au moins un copolymère photo-amorceur selon la revendication 1.

**4.** Procédé selon la revendication 3, caractérisé en ce qu'on ajoute au mélange à polymériser de 0,1 à 20% en poids d'un copolymère photo-amorceur selon la revendication 1.

**5.** Systèmes photopolymérisables contenant au moins un composé photopolymérisable à insaturation éthylènique ainsi qu'éventuellement d'autres adjuvants connus et usuels, caractérisé en ce qu'ils contiennent au moins un copolymère photo-amorceur selon la revendication 1.

**6.** Utilisation des copolymères selon la revendication 1 en tant que composants agissant simultanément comme composants photo-amorçants et formant des couches dans les systèmes durcissables par irradiation.

**7.** Systèmes durcissables par irradiation se composant essentiellement d'un ou plusieurs copolymères selon la revendication 1.

**8.** Procédé pour la préparation d'un revêtement durci par irradiation sur un substrat en enduisant ce substrat par un système photopolymérisable et en réalisant le durcissement par irradiation avec des rayons UV d'une longueur d'onde comprise de 250 et 600 nm, caractérisé en ce qu'on utilise un système selon la revendication 5 ou 7.